(19) Europäisches Patentamt
European Patent Office
Office européen des brevets

(11) EP 3 166 154 A1

(12) EUROPEAN PATENT APPLICATION
published in accordance with Art. 153(4) EPC

(43) Date of publication:
10.05.2017 Bulletin 2017/19

(21) Application number: 15814293.5

(22) Date of filing: 24.06.2015

(51) Int Cl.:
*H01L 41/193* (2006.01) *B32B 7/02* (2006.01)
*B32B 27/36* (2006.01) *C08L 67/04* (2006.01)
*C08L 101/16* (2006.01) *H01L 41/053* (2006.01)
*H01L 41/083* (2006.01) *H01L 41/09* (2006.01)
*H01L 41/253* (2013.01) *H01L 41/45* (2013.01)

(86) International application number:
PCT/JP2015/068231

(87) International publication number:
WO 2016/002604 (07.01.2016 Gazette 2016/01)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA

(30) Priority: 02.07.2014 JP 2014136759

(71) Applicant: Mitsui Chemicals, Inc.
Minato-ku
Tokyo 105-7122 (JP)

(72) Inventors:
- TANIMOTO, Kazuhiro
Nagoya-shi, Aichi 457-8522 (JP)
- YOSHIDA, Mitsunobu
Nagoya-shi, Aichi 457-8522 (JP)
- NISHIKAWA, Shigeo
Nagoya-shi, Aichi 457-8522 (JP)

(74) Representative: Hoffmann Eitle
Patent- und Rechtsanwälte PartmbB
Arabellastraße 30
81925 München (DE)

# (54) POLYMER PIEZOELECTRIC MATERIAL, LAMINATE BODY, METHOD FOR PRODUCING POLYMER PIEZOELECTRIC MATERIAL, AND METHOD FOR PRODUCING LAMINATE BODY

(57) A polymeric piezoelectric material, comprising at least two regions, the at least two regions comprising: a region H, which is an oriented polymeric piezoelectric region that includes an optically active helical chiral polymer (A) having a weight average molecular weight of from 50,000 to 1,000,000, the region H having a crystallinity obtained by a DSC method of from 20% to 80% and having a standardized molecular orientation measured by a microwave transmission-type molecular orientation meter based on a reference thickness of 50 μm of from 3.5 to 15.0; and a region L, which is a low orientation region that includes the optically active helical chiral polymer (A) having a weight average molecular weight of from 50,000 to 1,000,000, the region L being present near at least part of an end portion of the region H, having an average width when viewed from a normal direction with respect to the principal plane of the region H of from 10 μm to 300 μm, and having a retardation is 100 nm or less.

Fig. 1

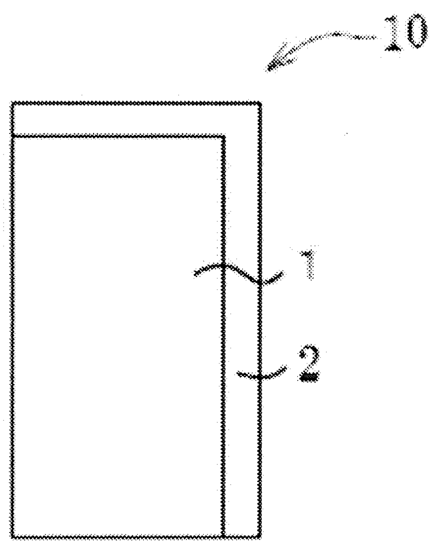


EP 3 166 154 A1

## Description

### Technical Field

The present invention relates to a polymeric piezoelectric material, a layered body, a method of manufacturing a polymeric piezoelectric material, and a method of manufacturing a layered body.

### Background Art

Although PZT ($PbZrO_3$-$PbTiO_3$ solid solution) which is a ceramic material is conventionally used for a piezoelectric material in many cases, since PZT contains lead, a polymeric piezoelectric material whose environmental load is low, and which is flexible is increasingly used.
As a polymeric piezoelectric material, a Pauling-type polymer represented by nylon 11, polyvinyl fluoride, polyvinyl chloride, polyurea, polyvinylidene fluoride (β-type) (PVDF), vinylidene fluoride -trifluoro ethylene copolymer (P(VDF-TrFE)) (75/25), or the like is known.
In recent years, a technique of using, other than the above, an optically active helical chiral polymer (for example, a polylactic acid-type polymer represented by a polylactic acid) as a polymeric piezoelectric material has been reported.
For example, a polymeric piezoelectric material exhibiting a piezoelectric modulus of approximately 10 pC/N at normal temperature, which is attained by a stretching treatment of a molding of a polylactic acid, has been disclosed (see, for example, Document 1).
It has been also reported that a high piezoelectricity of approximately 18 pC/N can be achieved by a special orientation method called a forging process for highly orientating a polylactic acid crystal (see, for example, Document 2).

Document 1 Japanese Patent Application Laid-Open (JP-A) No. H05-152638
Document 2 JP-A No. 2005-213376

## SUMMARY OF INVENTION

### Technical Problem

Since a molecularly oriented polymeric piezoelectric material is likely to be torn parallel to the orientation direction, cutting conditions need to be adjusted so that the polymeric piezoelectric material is hardly to be torn when the material is cut. However, the present inventors found problems that, even when cutting conditions are adjusted to prevent generation of tear during cutting, a polymeric piezoelectric material made from a polylactic acid or the like is likely to generate a crack after cutting and heating in a machining process or in a product, and that, especially when a layered structure is formed by the polymeric piezoelectric material and another material or the like, a gap is generated between the polymeric piezoelectric material and another material due to generation of a crack, whereby the electrical property of the layered structure is likely to be nonuniform.
The present invention has been made in view of the above-described problems, and an object of the invention is to provide a polymeric piezoelectric material in which generation of a crack when a layered body is heated is suppressed, and in which generation of a space (air inclusion) at an interface between a polymeric piezoelectric layer and another layer is suppressed, and a method of manufacturing the polymeric piezoelectric material.
An object of the invention is to provide a layered body in which generation of a crack is suppressed when the layered body is heated, and in which generation of a space (air inclusion) at an interface between a polymeric piezoelectric layer and another layer is suppressed, and a method of manufacturing the layered body.

### Solution to Problem

Specific means to solve the problems are, for example, as follows.

<1> A polymeric piezoelectric material, comprising at least two regions, the at least two regions comprising: a region H, which is an oriented polymeric piezoelectric region that includes an optically active helical chiral polymer (A) having a weight average molecular weight of from 50,000 to 1,000,000, the region H having a crystallinity obtained by a DSC method of from 20% to 80% and having a standardized molecular orientation measured by a microwave transmission-type molecular orientation meter based on a reference thickness of 50 μm of from 3.5 to 15.0; and a region L, which is a low orientation region that includes the optically active helical chiral polymer (A) having a weight average molecular weight of from 50,000 to 1,000,000, the region L being present near at least part of an end portion of the region H, having an average width when viewed from a normal direction with respect to the principal plane

of the region H of from 10 μm to 300 μm, and having a retardation is 100 nm or less.

<2> The polymeric piezoelectric material according to <1>, wherein the region L is at least present near an end portion of the region H which intersects the direction of molecular orientation of the region H.

<3> The polymeric piezoelectric material according to <1> or <2>, wherein a piezoelectric constant $d_{14}$ measured at 25°C by a stress-charge method is 1 pC/N or more.

<4> The polymeric piezoelectric material according to any one of <1> to <3>, wherein a product of the standardized molecular orientation and the crystallinity of the region H is from 25 to 700.

<5> The polymeric piezoelectric material according to any one of <1> to <4>, wherein the region H has an internal haze with respect to visible light of 50% or less.

<6> The polymeric piezoelectric material according to any one of <1> to <5>, wherein the helical chiral polymer (A) is polylactic acid-type polymer having a main chain containing a repeating unit represented by the following Formula (1).

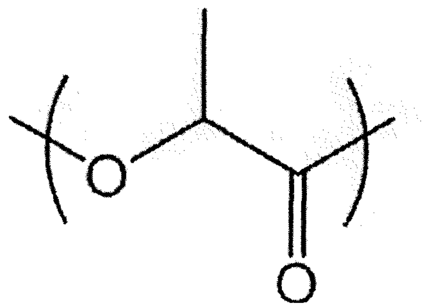

(1)

<7> The polymeric piezoelectric material according to any one of <1> to <6>, wherein the region L is a region formed by irradiation of a laser beam having a wavelength of 12,000 nm or less.

<8> A layered body, comprising: a polymeric piezoelectric layer containing the polymeric piezoelectric material according to any one of <1> to <7>; and a surface layer, which is arranged on at least one principle plane of the polymeric piezoelectric layer, and which is composed of a thermoplastic resin other than the helical chiral polymer (A).

<9> The layered body according to <8>, wherein the thermoplastic resin is a polyester resin.

<10> The layered body according to <8> or <9>, further comprising a pressure-sensitive adhesive layer between the polymeric piezoelectric layer and the surface layer.

<11> A method of manufacturing the polymeric piezoelectric material according to any one of <1> to <7>, the method comprising: preparing a piezoelectric material comprising a region H1, which is an oriented polymeric piezoelectric region that includes an optically active helical chiral polymer (A) having a weight average molecular weight of from 50,000 to 1,000,000, the region H1 having a crystallinity obtained by a DSC method of from 20% to 80%, and having a standardized molecular orientation measured by a microwave transmission-type molecular orientation meter based on a reference thickness of 50 μm of from 3.5 to 15.0; and irradiating the piezoelectric material with a laser beam having a wavelength of 10,600 nm or less in order to machine the piezoelectric material and to alter the properties of a part of the region H1, thereby forming the region L, whereby the piezoelectric material is made into a polymeric piezoelectric material including the region H and the region L.

<12> A method of manufacturing a layered body, the method comprising: manufacturing a polymeric piezoelectric material by the manufacturing method according to <11>; and forming, on at least one principal plane of a polymeric piezoelectric layer containing the polymeric piezoelectric material, a surface layer composed of a thermoplastic resin other than the helical chiral polymer (A).

<13> A method of manufacturing the layered body according to any one of <8> to <10>, the method comprising: preparing a piezoelectric material comprising a region H1, which is an oriented polymeric piezoelectric region that includes an optically active helical chiral polymer (A) having a weight average molecular weight of from 50,000 to 1,000,000, the region H1 having a crystallinity obtained by a DSC method of from 20% to 80%, and having a standardized molecular orientation measured by a microwave transmission-type molecular orientation meter based on a reference thickness of 50 μm of from 3.5 to 15.0; forming, on at least one principal plane of a piezoelectric layer containing the piezoelectric material, a surface layer composed of a thermoplastic resin other than the helical chiral polymer (A); and irradiating the piezoelectric layer and the surface layer with a laser beam having a wavelength of 10,600 nm or less in order to machine the piezoelectric material and to alter the properties of part of the region H1, thereby forming the region L, whereby the piezoelectric layer is made into the polymeric piezoelectric layer including the region H and the region L.

Advantageous Effects of Invention

According to the invention, a polymeric piezoelectric material in which generation of a crack when a layered body is heated is suppressed, and in which generation of a space (air inclusion) at an interface between a polymeric piezoelectric layer and another layer is suppressed, and a method of manufacturing the polymeric piezoelectric material can be provided.

According to the invention, a layered body in which generation of a crack is suppressed when the layered body is heated, and in which generation of a space (air inclusion) at an interface between a polymeric piezoelectric layer and another layer is suppressed, and a method of manufacturing the layered body can be provided.

BRIEF DESCRIPTION OF DRAWINGS

Fig. 1 is a diagram illustrating a polymeric piezoelectric material according to the present embodiment.

DESCRIPTION OF EMBODIMENTS

Here, a numerical range represented by "from A to B" means a range including numerical values A and B as a lower limit value and an upper limit value, respectively.

Here, a "film" (for example, a "polymer film") is a concept including a sheet (for example, a polymer sheet).

[Polymeric Piezoelectric Material]

A polymeric piezoelectric material according to one embodiment of the invention comprises at least two regions, the at least two regions comprising: a region H, which is an oriented polymeric piezoelectric region that includes an optically active helical chiral polymer (A) having a weight average molecular weight of from 50,000 to 1,000,000, the region H having a crystallinity obtained by a DSC method of from 20% to 80% and having a standardized molecular orientation measured by a microwave transmission-type molecular orientation meter based on a reference thickness of 50 μm of from 3.5 to 15.0; and a region L, which is a low orientation region that includes the optically active helical chiral polymer (A) having a weight average molecular weight of from 50,000 to 1,000,000, the region L being present near at least part of an end portion of the region H, having an average width when viewed from a normal direction with respect to the principal plane of the region H of from 10 μm to 300 μm, and having a retardation is 100 nm or less.

As described above, a polymeric piezoelectric material according to the present embodiment includes a region L which is a low orientation region near at least part of an end portion of the region H, and in the region L, the helical chiral polymer (A) is amorphous and has low orientation. When the polymeric piezoelectric material includes such a region L, the tearability of the polymeric piezoelectric material in a direction parallel to the orientation direction is suppressed, and generation of a crack when a layered body made from the polymeric piezoelectric material is heated is suppressed. It is also assumed that, since a gap between a polymeric piezoelectric material (polymeric piezoelectric layer) and another layer which is generated when a crack is generated can be suppressed, electrical properties of a layered body can be made uniform.

Furthermore, since the average width of the region L of the polymeric piezoelectric material viewed from the normal direction with respect to a principal plane of the region H is 10 μm to 300 μm, high piezoelectricity of the polymeric piezoelectric material is maintained. Generation of a crack originating from a low orientation region when a layered body is formed can be suppressed, and generation of a space (air inclusion) at an interface between a polymeric piezoelectric layer formed from a polymeric piezoelectric material and another layer can be suppressed.

<Region H>

A polymeric piezoelectric material according to the present embodiment includes an optically active helical chiral polymer (A) having a weight average molecular weight of from 50,000 to 1,000,000, and includes a region H which is an oriented polymeric piezoelectric region whose crystallinity obtained by a DSC method is from 20% to 80%, and whose standardized molecular orientation measured by a microwave transmission-type molecular orientation meter based on a reference thickness of 50 μm is from 3.5 to 15.0.

< Region L>

A polymeric piezoelectric material according to the present embodiment includes an optically active helical chiral polymer (A) having a weight average molecular weight of from 50,000 to 1,000,000, and includes a region L which is a low orientation region which is present near at least part of an end portion of the region H, whose average width

viewed from the normal direction with respect to a principal plane of the region H is from 10 μm to 300 μm, and whose retardation is 100 nm or less.

Here, the term "principal plane" refers to a plane having the largest area among the surfaces of the polymeric piezoelectric material. The polymeric piezoelectric material of the present embodiment may have two or more principal planes. For example, when the polymeric piezoelectric material is a plate body having two plates A with a size of length 10 mm × width 0.3 mm, two plates B with a size of length 3 mm × width 0.3 mm, and two plates C with a size of length 10 mm × width 3 mm, the principal plane of the polymeric piezoelectric material is the plate C, and the plate body has two principal planes.

In a polymeric piezoelectric material according to the present embodiment, the region L may be present near at least part of an end portion of the region H, and is preferably present near an end portion of the region H crossing the molecular orientation direction of the region H. By this, the tearability of the polymeric piezoelectric material in a direction parallel to the orientation direction is suitably suppressed, and generation of a crack when a layered body which is formed from a polymeric piezoelectric material is heated is more suitably suppressed.

Examples of an aspect in which the region L is present near at least part of an end portion of the region H include an aspect in which the region L is in contact with at least part of an end portion of the region H. For example, as illustrated in Fig. 1, a polymeric piezoelectric material according to the present embodiment may be a polymeric piezoelectric material 10 in which the region L (low orientation region 2) is in contact with two sides of the rectangle region H (oriented polymeric piezoelectric region 1).

Other examples of an aspect in which the region L is present near at least part of an end portion of the region H include an aspect in which the region H is surrounded by the region L.

The region L is preferably a region formed by irradiation of a laser beam having a wavelength of 12,000 nm or less. In other words, it is preferable that the region L which is a low orientation region is formed by irradiating part of the oriented polymeric piezoelectric region with a laser beam having a wavelength of 12,000 nm or less to alter the properties of the oriented polymeric piezoelectric region. When the oriented polymeric piezoelectric region is irradiated with a laser beam, a region which is irradiated with a laser beam absorbs energy of the laser beam, and the surface temperature of the irradiated region is rapidly elevated to reach the melting point or the glass transition temperature thereof, whereby a phase change occurs. The region which is irradiated with a laser beam and therearound melt by the heat generated at this time to form the region L.

Furthermore, it is preferable that, by irradiating the oriented polymeric piezoelectric region with a laser, the region L is formed by altering the properties of the oriented polymeric piezoelectric region, and at the same time, a piezoelectric material including a region H1 which is an oriented polymeric piezoelectric region is subjected to laser processing. In the laser processing, a laser beam output from a predetermined laser generator is focused by a lens, and a piezoelectric material including the region H1 which is an oriented polymeric piezoelectric region or a layered structure of a substrate layer containing the piezoelectric material and a surface layer composed of a thermoplastic resin or the like is irradiated with the laser beam. Together with the irradiation, the laser irradiation position is moved along a predetermined processing line, whereby a predetermined processing is performed. Examples of a laser processing include a shape processing such as cutting, drilling, marking, grooving, scribing, or trimming.

Here, "a piezoelectric material including a region H1 which is an oriented polymeric piezoelectric region" refers to a material which is used for manufacturing a polymeric piezoelectric material according to the present embodiment. By altering the properties of part of the region H1 of the piezoelectric material and processing the piezoelectric material, a polymeric piezoelectric material including the region L can be obtained. In the present embodiment, since a region of the region H1 which is an oriented polymeric piezoelectric region, whose properties have not been altered into those of the region L, corresponds to the region H, the region H1 and the region H exhibit the same physical properties (crystallinity, standardized molecular orientation, birefringence, internal haze, and the like).

The irradiated laser beam in the present embodiment is not particularly limited, and a variety of conventionally known ones can be employed. For example, an ArF excimer laser, a KrF excimer laser, a XeCl excimer laser, a third harmonic or a fourth harmonic of a YAG laser, a third harmonic or a fourth harmonic of a YLF or YVO4 solid-state laser, a Ti:S laser, a semiconductor laser, a fiber laser, a carbon dioxide laser, or the like can be used. Among these laser beams, a laser having an oscillation wavelength of 12,000 nm or less is preferable, and a laser having an oscillation wavelength of 10,600 nm or less is more prefeable. Among laser beams, a carbon dioxide laser having an ocsillation wavelength of 10,600 nm or less or the like is particularly preferably from a viewpoint of improving a machining speed and a yield.

In the case of a cutting processing, the power density of a laser beam can be set depending on the cutting speed of the cutting processing. A laser beam having a wavelength ranging from ultraviolet rays to near infrared rays cay be generated by selecting an oscillation medium or crystal. Therefore, by using a laser beam which is adjusted to a light absorption wavelength of an object to be processed, a processing can be performed efficiently with a low power density. In the case of laser processin in the present embodiment, the power density is preferably from 50W to 700W.

The configuration of the region L of a polymeric piezoelectric material according to the present embodiment is

not limited to a configuration which is formed by irradiating part of an oriented polymeric piezoelectric region with a laser beam to alter the properties of the oriented polymeric piezoelectric region as described above, and may be a configuration in which a piezoelectric material including a region H which is an oriented polymeric piezoelectric region and a piezoelectric material including a region L which is a low orientation region are prepared separately to manufacture a polymeric piezoelectric material according to the present embodiment by sticking them together.

The average width of the region L can be controlled by adjusting, for example, a focused beam diameter, a power density, a cutting speed. The average width of the region L is preferably from 10 μm to 300 μm, more preferably from 20 μm to 250 μm, and still more preferably from 30 μm to 200 μm. When the average width of the region L is 10 μm or more, generation of a crack in the MD direction can be suppressed. On the other hand, when the average width of the region L is 300 μm or less, deterioration of piezoelectricity can be suppressed, and when a device using a polymeric piezoelectric material is manufactured, deterioration or variation of performance of the device can be suppressed. Furthermore, when the average width of the region L is 300 μm or less, generation of a projection at an end portion where a polymeric piezoelectric material is processed can be suppressed, and generation of air inclusion when a layered body is formed can be suppressed.

A method of forming a region L by altering the properties of an oriented polymeric piezoelectric region is not limited to laser beam irradiation as long as the average width of the region L can be adjusted to from 10 μm to 300 μm. For example, part of the oriented polymeric piezoelectric region may be melted by a soldering iron or a heated punching blade to form the region L having an average width of from 10 μm to 300 μm.

The piezoelectricity of a polymeric piezoelectric material can be evaluated, for example, by measuring a piezoelectric constant $d_{14}$ of the polymeric piezoelectric material. The larger the piezoelectric constant $d_{14}$ is, the higher the piezoelectricity is.

The transparency of a polymeric piezoelectric material can be evaluated, for example, by measuring an internal haze. The smaller the internal haze is, the higher the transparency is.

< Piezoelectric Constant $d_{14}$ (Stress-Charge Method) >

The piezoelectricity of a polymeric piezoelectric material can be evaluated, for example, by measuring a piezoelectric constant $d_{14}$ of the polymeric piezoelectric material. The piezoelectric constant $d_{14}$ of a polymeric piezoelectric material is a piezoelectric constant of the region H and the region L.

Hereinafter, an example of a method of measuring the piezoelectric constant $d_{14}$ by a stress-charge method will be described.

First, a polymeric piezoelectric material is cut to a length of 150 mm in the direction of 45° with respect to the stretching direction (MD direction) of the polymeric piezoelectric material, and to 50 mm in the direction perpendicular to the above 45° direction, to prepare a rectangular specimen. Subsequently, the prepared specimen is set on a stage of Showa Shinku SIP-600, and aluminum (hereinafter, referred to as "Al") is deposited on one surface of the specimen such that the deposition thickness of Al becomes about 50 nm. Subsequently, Al is deposited on the other surface of the specimen similarly. Both surfaces of the specimen are covered with Al to form conductive layers of Al.

The specimen of 150 mm×50 mm having the Al conductive layers formed on both surfaces is cut to a length of 120 mm in the direction of 45° with respect to the stretching direction (MD direction) of the polymeric piezoelectric material, and to 10 mm in the direction perpendicular to the above 45° direction, to cut out a rectangular film of 120 mm×10 mm. This film is used as a sample for measuring a piezoelectric constant.

The sample thus obtained is set in a tensile testing machine (TENSILON RTG-1250 manufactured by A&D Company, Limited) having a distance between chucks, of 70 mm so as not to be slack. A force is applied periodically at a crosshead speed of 5 mm/min such that the applied force reciprocates between 4 N and 9 N. In order to measure a charge amount generated in the sample according to the applied force at this time, a capacitor having an electrostatic capacity Qm (F) is connected in parallel to the sample, and a voltage V between the terminals of this capacitor Cm (95 nF) is measured through a buffer amplifier. The above measurement is performed under a temperature condition of 25°C. A generated charge amount Q (C) is calculated as a product of the capacitor capacity Cm and a voltage Vm between the terminals. The piezoelectric constant $d_{14}$ is calculated by the following formula.

$$d_{14} = (2 \times t)/L \times Cm \cdot \Delta Vm/\Delta F$$

t: sample thickness (m)
L: distance between chucks (m)
Cm: capacity (F) of capacitor connected in parallel
ΔVm/ΔF: ratio of change amount of voltage between terminals of capacitor with respect to change amount of force

A higher piezoelectric constant $d_{14}$ results in a larger displacement of the polymeric piezoelectric material with respect to a voltage applied to the polymeric piezoelectric material, and reversely a higher voltage generated responding to a force applied to the polymeric piezoelectric material, and therefore is advantageous as a polymeric piezoelectric material. Specifically, in the polymeric piezoelectric material according to the invention, the piezoelectric constant $d_{14}$ measured at 25°C by a stress-charge method is 1 pC/N or more, preferably 3 pC/N or more, and more preferably 4 pC/N or more. The upper limit of the piezoelectric constant $d_{14}$ is not particularly limited, and is preferably 50 pC/N or less, and more preferably 30 pC/N or less, for a polymeric piezoelectric material using a helical chiral polymer from a viewpoint of a balance with transparency, or the like described below. Similarly, from a viewpoint of the balance with transparency, the piezoelectric constant $d_{14}$ measured by a resonance method is preferably 15 pC/N or less.
Here, the "MD direction" is a direction (Machine Direction) in which a film flows, and a "TD direction" is a direction (Transverse Direction) perpendicular to the MD direction and parallel to a principal plane of the film.

< Internal Haze >

Transparency of the region H (region H1 of a piezoelectric material) of a polymeric piezoelectric material according to the present embodiment can be evaluated by measuring the internal haze.
The internal haze of the region H with respect to visible light is preferably 50% or less.
Here, the internal haze of the region H is a haze of the region H excepting a haze due to the shape of the outer surface thereof.
The internal haze is a value obtained when a haze of the region H (region H1 of a piezoelectric material) of a polymeric piezoelectric material having a thickness of from 0.03 mm to 0.05 mm is measured in accordance with JIS-K7105 using a haze measuring machine [TC-HIII DPK manufactured by Tokyo Denshoku Co., Ltd.,] at 25°C. Details of the measurement method will be described in Examples. Furthermore, the internal haze of the polymeric piezoelectric body is preferably 40% or less, more preferably 20% or less, still more preferably 13% or less, and further still more preferably 5% or less. Furthermore, the internal haze of the polymeric piezoelectric body is preferably 2.0% or less, and particularly preferably 1.0% or less from a viewpoint of further improving the transparency and longitudinal tear strength.
The lower the internal haze of the polymeric piezoelectric body is, the better the polymeric piezoelectric body is. From a viewpoint of the balance with the piezoelectric constant, etc. the internal haze is preferably from 0.0% to 40%, more preferably 0.01% to 20%, still more preferably 0.01 % to 5%, further still more preferably 0.01 % to 2.0%, and particularly preferably 0.01% to 1.0%.
In a polymeric piezoelectric material according to the present embodiment, preferably, the internal haze of the region H with respect to visible light is 1.0% or less, and the piezoelectric constant $d_{14}$ of the polymeric piezoelectric material measured by a stress-charge method at 25°C is 1.0 pC/N or more.
Next, MORc and crystallinity will be described.

< Standardized Molecular Orientation MORc >

The standardized molecular orientation MORc is a valued based on "degree of molecular orientation MOR" which is an indication representing a degree of orientation of the helical chiral polymer (A).
Here, the degree of molecular orientation MOR (Molecular Orientation Ratio) is measured by the following microwave measure method. That is, a polymeric piezoelectric material (for example, a polymeric piezoelectric material in a film shape) is placed in a microwave resonant waveguide of a well-known microwave molecular orientation ratio measuring apparatus (also referred to as a "microwave transmission-type molecular orientation meter") such that the surface of the polymeric piezoelectric material (film surface) is perpendicular to a traveling direction of the microwaves. Then, while the polymeric piezoelectric material is continuously irradiated with microwaves an oscillating direction of which is biased unidirectionally, the sample is rotated in a plane perpendicular to the traveling direction of the microwaves from 0 to 360°, and the intensity of the microwaves which have passed through the sample is measured to determine the molecular orientation ratio MOR.
The standardized molecular orientation MORc means a degree of molecular orientation MOR obtained based on the reference thickness tc of 50 μm, and can be determined by the following formula.

$$MORc = (tc/t) \times (MOR - 1) + 1$$

(tc: reference thickness to which the thickness should be corrected; t: thickness of polymeric piezoelectric material)
The standardized molecular orientation MORc can be measured by a known molecular orientation meter, for example, a microwave molecular orientation meter MOA-2012A or MOA-6000 manufactured by Oji Scientific Instruments,

at a resonance frequency around 4 GHz or 12 GHz.

In a polymeric piezoelectric material according to the present embodiment, the standardized molecular orientation MORc of the region H is preferably from 3.5 to 15.0.

When the standardized molecular orientation MORc is 3.5 or more, the number of molecular chains of the molecularly orientated helical chiral polymer (A) in the polymeric piezoelectric material is large, and as the result, a high piezoelectricity of the polymeric piezoelectric material is maintained.

When the standardized molecular orientation MORc is 15.0 or less, a decrease in transparency due to an excessively large amount of molecular chains of a molecularly orientated helical chiral polymer (A) is suppressed, and as the result, a high transparency of the polymeric piezoelectric material is maintained.

The standardized molecular orientation MORc of the region H is more preferably from 3.5 to 10.0 and still more preferably from 4.0 to 8.0.

When the polymeric piezoelectric material is, for example, a stretched film, the standardized molecular orientation MORc can be contolled by heat treatment conditions (heating temperature and heating time) before stretching, stretching conditions (stretching temperature and stretching speed), or the like.

The standardized molecular orientation MORc can be converted to birefringence $\Delta n$ which is obtained by dividing retardation by a film thickness.

Specifically, the retardation can be measured, for example, by a Birefringence Measurement System WPA-Micro manufactured by Photonic Lattice, Inc., RETS 100 manufactured by Otsuka Electronics Co., Ltd., or the like. MORc and $\Delta n$ are approximately in a linearly proportional relationship. When $\Delta n$ is 0, MORc is 1.

For example, when the helical chiral polymer (A) is a polylactic acid-type polymer and the birefringence $\Delta n$ of the polymeric piezoelectric material is measured at measurement wavelength of 550 nm, the lower limit 2.0 of a preferable range for the standardized molecular orientation MORc can be converted to the birefringence $\Delta n$ of 0.005. The lower limit 40 of a preferable range of a product of the standardized molecular orientation MORc and the crystallinity of the polymeric piezoelectric material which will be mentioned below can be converted to 0.1 as a product of the birefringence $\Delta n$ and the crystallinity of the polymeric piezoelectric material.

< Retardation of Region L >

The retardation of the region L is from 100 nm to 0 nm, preferably from 90 nm to 0 nm, more preferably from 80 nm to 0 nm, still more preferably from 70 nm to 10 nm, and particularly preferably from 60 nm to 20 nm. When the retardation of the region L satisfies the numerical ranges, the region L is amorphous and has low orientation, and, tearability of a polymeric piezoelectric material in a direction parallel to the orientation direction is suppressed, thereby suppressing generation of a crack. Furthermore, when the retardation of the region L satisfies the above-mentioned numerical ranges, the polymeric piezoelectric material has an excellent adhesion with another member.

< Degree of Crystallinity >

In a polymeric piezoelectric material according to the present embodiment, the crystallinity of the region H is determined by a DSC method. The measurement method will be described in detail in Examples.

As described above, the crystallinity of the region H of the polymeric piezoelectric material is from 20% to 80%.

When the crystallinity is 20% or more, the piezoelectricity of the polymeric piezoelectric material is maintained high.

When the crystallinity is 80% or less, the transparency of the polymeric piezoelectric material is maintained high; and when the crystallinity is 80% or less, since whitening or a break is less likely to occur during stretching, the polymeric piezoelectric material can be manufactured easily.

Therefore, the crystallinity of the region H of the polymeric piezoelectric material is preferably from 20% to 80%, more preferably from 25% to 70%, and still more preferably from 30% to 50%.

< Product of Standardized Molecular Orientation MORc and Crystallinity >

The product of the standardized molecular orientation MORc and the crystallinity of the region H of the polymeric piezoelectric material is not particularly limited, and is preferably from 25 to 700, more preferably from 75 to 680, further preferably from 90 to 660, still further preferably from 125 to 650, and particularly preferably from 150 to 350. When the above product is within a range of from 25 to 700, a balance between the piezoelectricity and the transparency of the polymeric piezoelectric material is favorable and the dimensional stability is high, and therefore, the polymeric piezoelectric material can be suitably used for a piezoelectric element described below.

In the present embodiment, it is possible to adjust the product within the above range, for example, by adjusting the conditions of crystallization and stretching when the polymeric piezoelectric material is manufactured.

The shape of a polymeric piezoelectric material according to the present embodiment is not particularly limited, and is preferably a shape of a film.
The thickness (for example, the thickness of a polymeric piezoelectric material in a shape of a film) of a polymeric piezoelectric material is not particularly limited, and is preferably from 10 μm to 400 μm, more preferably from 20 μm to 200 μm, further preferably from 20 μm to 100 μm, and particularly preferably from 20 μm to 80 μm.

< Tensile Modulus of Elasticity >

When the tensile modulus of elasticity of the region H of a polymeric piezoelectric material according to the present embodiment is evaluated by a testing method in accordance with JIS Z-6732, the tensile modulus of elasticity of a film having a thickness of 50 μm is preferably from 0.1 GPa to 100 GPa, more preferably from 1 GPa to 50 GPa, still more preferably from 1.5 GPa to 30 GPa, and particularly preferably from 2 GPa to 10 GPa.
When the tensile modulus of elasticity of the region H of a polymeric piezoelectric material is 0.1 GPa or more, a sufficient shape retainability can be suitably secured, and when the tensile modulus of elasticity is 100 GPa or less, brittleness of a film can be suitably suppressed.
The tensile modulus of elasticity of the region H of a polymeric piezoelectric material can be adjusted by the composition, the stretching ratio, the heating conditions, and the like of the film.
For example, by increasing the stretching ratio, the tensile modulus of elasticity of a polymeric piezoelectric material can be increased.
Alternatively, the tensile modulus of elasticity of the region H of a polymeric piezoelectric material according to the present embodiment may be measured by a method in accordance with JIS K7161. Specifically, a film may be cut to prepare a strip speciment having a width (a direction perpendicular to a stretching direction of a polymeric piezoelectric material) of 10 mm and a length (a stretching direction of a polymeric piezoelectric material) of 120 mm; and the tensile modulus of elasticity of the specimen may be measured using a tensile testing machine at a temperature of 23°C, under conditions of a distance between chucks 100 mm and a pulling speed of 100 mm/min. The tensile modulus of elasticity of a specimen is preferably from 0.1 GPa to 100 GPa, and more preferably from 0.1 GPa to 50 GPa.
In the present embodiment, the phrase "stretching direction" means an extended direction of a molecular chain of a polymeric piezoelectric material; or a direction in which the tensile modulus of elasticity is from 0.1 GPa to 100 GPa. The phrase "a direction perpendicular to a stretching direction" means a direction perpendicular to an extended direction of a molecular chain of a polymeric piezoelectric material.
Next, a helical chiral polymer (A) and other components included in the region H and the region L of a polymeric piezoelectric material according to the present embodiment will be described.

< Helical Chiral Polymer (A) >

The region H and the region L of a polymeric piezoelectric material according to the present embodiment include a helical chiral polymer (A).
In the present embodiment, the helical chiral polymer (A) has a weight average molecular weight of from 50,000 to 1,000,000, and is an optically active helical chiral polymer.
Here, the term "optically active helical chiral polymer" refers to a polymer whose molecular structure is a helical structure and which is optically active.
Examples of the helical chiral polymer (A) include polypeptide, cellulose derivatives, polylactic acid-type polymer, polypropylene oxide, and poly(β-hydroxy butyric acid).
Examples of the polypeptides include poly(glutaric acid γ-benzyl) and poly(glutaric acid γ-methyl).
Examples of the cellulose derivatives include acetic acid cellulose and cyano ethyl cellulose.
From a viewpoint of improving the piezoelectricity of a polymeric piezoelectric material, the optical purity of the helical chiral polymer (A) is preferably 95.00%ee or more, more preferably 96.00%ee or more, still more preferably 99.00%ee or more, and still further preferably 99.99%ee or more. Desirebly, the the optical purity is 100.00%ee. It is considered that, by the optical purity of the helical chiral polymer (A) within the above range, a packing property of a polymer crystal exhibiting piezoelectricity is enhanced, and as a result, the piezoelectricity is increased.
Here, the optical purity of the helical chiral polymer (A) is a value calculated according to the following formula.

$$\text{Optical purity (\%ee)} = 100 \times |\text{L-form amount - D-form amount}|/(\text{L-form amount + D-form amount})$$

That is, the optical purity of the helical chiral polymer (A) is a value obtained by multiplying (multiplying) 'the

value obtained by dividing (dividing) "the amount difference (absolute value) between the amount [% by mass] of helical chiral polymer (A) in L-form and the amount [% by mass] of helical chiral polymer (A) in D-form" by "the total amount of the amount [% by mass] of helical chiral polymer (A) in L-form and the amount [% by mass] helical chiral polymer (A) in D-form"' by '100'.

For the amount [% by mass] of helical chiral polymer (A) in L-form and the amount [% by mass] of helical chiral polymer (A) in D-form, values obtained by a method using a high performance liquid chromatography (HPLC) are used. Description of the measurement method will be described in detail in Examples.

For the above helical chiral polymer (A), a polymer having a main chain containing a repeating unit represented by the following Formula (1) from a viewpoint of increasing the optical purity and improving the piezoelectricity.

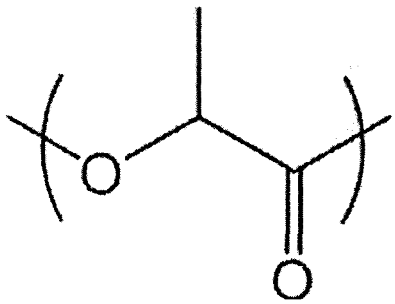

(1)

Examples of the polymer having a main chain including a repeating unit represented by the following Formula (1) include a polylactic acid-type polymer.

Here, the term "polylactic acid-type polymer" refers to "polylactic acid (a polymer consisting only of a repeating unit derived from a monomer selected from L-lactic acid or D-lactic acid)", "a copolymer of L-lactic acid or D-lactic acid and a compound copolymerizable with the L-lactic acid or D-lactic acid", or a mixture thereof.

Among polylactic acid-type polymers, a polylactic acid is preferable, and a homopolymer (PLLA) of L-lactic acid or a homopolymer (PDLA) of D-lactic acid is most preferable.

Polylactic acid is a long polymer which is obtained by polymerizing lactic acid by ester bond to be connected with each other.

Polylactic acid is known to be manufactured by: a lactide method involving lactide; a direct polymerization method in which lactic acid is heated in a solvent under a reduced pressure to be polymerized while removing water; or the like.

Examples of the polylactic acid include a homopolymer of L-lactic acid, a homopolymer of D-lactic acid, a block copolymer including a polymer of at least one of L-lactic acid and D-lactic acid, and a graft copolymer including a polymer of at least one of L-lactic acid and D-lactic acid.

Examples of the "compound copolymerizable with the L-lactic acid or D-lactic acid" include a compound according to paragraph 0028 of WO 2013/054918.

Examples of the "a copolymer of L-lactic acid or D-lactic acid and a compound copolymerizable with the L-lactic acid or the D-lactic acid" include a block copolymer or a graft copolymer having a polylactic acid sequence capable of generating a helical crystal.

The concentration of a structure derived from a copolymer component in helical chiral polymer (A) is preferably 20 mol% or less.

For example, when the helical chiral polymer (A) is a polylactic acid-type polymer, the concentration of a structure derived from a copolymer component with respect to the total number of moles of a structure derived from lactic acid and a structure derived from a compound (copolymer component) copolymerizable with lactic acid is preferably 20 mol% or less.

A polylactic acid-type polymer can be manufactured by: a method of obtaining a polylactic acid by direct dehydration condensation of lactic acid as described in JP-A No. S59-096123 and JP-A No. H07-033861; a method of obtaining a polylactic acid by ring-opening polymerization using lactide which is a cyclic dimer of lactic acid as described in U.S. Patent No. 2,668,182, 4,057,357, and the like; or the like.

In order to make the optical purity of a polylactic acid-type polymer obtained by each of the above manufacturing methods 95.00%ee or more, for example, when polylactic acid is manufactured by a lactide method, it is preferable to polymerize lactide whose optical purity is enhanced to 95.00%ee or more by a crystallization operation.

- Weight Average Molecular Weight -

The weight average molecular weight (Mw) of helical chiral polymer (A) is from 50,000 to 1,000,000 as described

above.

Since the Mw of helical chiral polymer (A) is 50,000 or more, the mechanical strength of a polymeric piezoelectric material is improved. The Mw is preferably 100,000 or more, and more preferably 200,000 or more.

On the other hand, since the Mw of helical chiral polymer (A) is 1,000,000 or less, moldability when a polymeric piezoelectric material is obtained by molding (for example, extrusion molding). The Mw is preferably 800,000 or less, and more preferably 300,000 or less.

The molecular weight distribution (Mw/Mn) of the helical chiral polymer (A) is preferably from 1.1 to 5, and more preferably from 1.2 to 4 from a viewpoint of the strength of the polymeric piezoelectric material. The molecular weight distribution is still more preferably from 1.4 to 3.

The weight average molecular weight (Mw) and the molecular weight distribution (Mw/Mn) of the helical chiral polymer (A) are measured using a gel permeation chromatograph (GPC), and are values measured by the following GPC measurement method. Here, Mn is the number average molecular weight of the helical chiral polymer (A).

- GPC Measurement Apparatus -

GPC-100 manufactured by Waters Corp.

- Column -

Shodex LF-804 manufactured by Showa Denko K.K.

- Preparation of Sample -

The helical chiral polymer (A) is dissolved in a solvent (for example, chloroform) at 40°C to prepare a sample solution having a concentration of 1 mg/mL.

- Measurement Condition -

0.1 mL of the sample solution is introduced into a column at a temperature of temperature 40°C and a flow rate of 1 mL/min by using chloroform as a solvent.

The sample concentration in the sample solution separated by the column is measured by a differential refractometer. A universal calibration curve is created based on a polystyrene standard sample. The weight average molecular weight (Mw) and the molecular weight distribution (Mw/Mn) of the helical chiral polymer (A) are calculated.

For the polylactic acid-type polymer which is an example of the helical chiral polymer (A), a commercially available polylactic acid may be used.

Examples of the commercially available polylactic acid include PURASORB (PD, PL) manufactured by Purac Inc., LACEA (H-100, H-400) manufactured by Mitsui Chemicals, Inc., and Ingeo™ biopolymer manufactured by NatureWorks LLC.

When a polylactic acid-type polymer is used as the helical chiral polymer (A), it is preferable to manufacture the polylactic acid-type polymer by a lactide method or a direct polymerization method in order to make the weight average molecular weight (Mw) of the polylactic acid-type polymer 50,000 or more.

The polymeric piezoelectric material according to the present embodiment may include only one type of the above helical chiral polymer (A), or two or more of the above helical chiral polymers (A).

The content (total content when the material includes two or more types of the helical chiral polymers (A)) of the helical chiral polymer (A) in the polymeric piezoelectric material is preferably 80% by mass or more with respect to the total amount of the polymeric piezoelectric material.

< Stabilizer >

A polymeric piezoelectric material according to the present embodiment preferably includes, as a stabilizer, a compound which has one or more functional groups selected from the group consisting of a carbodiimide group, an epoxy group, and an isocyanate group and whose weight average molecular weight is from 200 to 60,000.

By this, a hydrolysis reaction of an optically active polymer (helical chiral polymer) is suppressed, thereby further improving the moist heat resistance of a film to be obtained.

Regarding a stabilizer, description in paragraphs 0039 to 0055 of WO 2013/054918 can be appropriately referred to.

< Antioxidant >

A polymeric piezoelectric material according to the present embodiment may include an antioxidant. The antioxidant is at least one selected from the group consisting of a hindered phenol-based compound, a hindered amine-based compound, a phosphite-based compound, and a thioether-based compound.

For the antioxidant, a hindered phenol-based compound or a hindered amine-based compound is preferably used. By this, a polymeric piezoelectric material having excellent moist heat resistance and transparency can be provided.

< Other Components >

A polymeric piezoelectric material according to the present embodiment may include other components, for example, known resins represented by polyvinylidene fluoride, a polyethylene resin, and a polystyrene resin; an inorganic filler such as silica, hydroxy apatite, montmorillonite; or known nucleating agents such as phthalocyanine, as long as effects of the invention are not compromised.

Regarding other components such as an inorganic filler and a nucleating agent, description of paragraphs 0057 to 0060 of WO 2013/054918 can be appropriately referred to.

When the polymeric piezoelectric material includes a component other than helical chiral polymer (A), the content of the component other than the helical chiral polymer (A) is preferably 20% by mass or less, and more preferably 10% by mass or less with respect to the total mass of the polymeric piezoelectric material.

The polymeric piezoelectric material preferably does not include the component other than the helical chiral polymer (A) from a veiw point of the transparency.

[Manufacturing Method of Polymeric Piezoelectric Material]

A method of manufacturing a polymeric piezoelectric material according to the present embodiment is not particularly limited.

A polymeric piezoelectric material according to the present embodiment can be preferably manufactured, for example, by a method comprising: a step of preparing a piezoelectric material comprising a region H1 which is an oriented polymeric piezoelectric region that includes an optically active helical chiral polymer (A) having a weight average molecular weight of from 50,000 to 1,000,000, the region H1 having a crystallinity obtained by a DSC method of from 20% to 80%, and having a standardized molecular orientation measured by a microwave transmission-type molecular orientation meter based on a reference thickness of 50 $\mu$m of from 3.5 to 15.0; and a step in which the piezoelectric material is irradiated with a laser beam having a wavelength of 10,600 nm or less in order to machine the piezoelectric material and to alter the properties of part of the region H1, thereby forming the region L.

A method of manufacturing a polymeric piezoelectric material according to the present embodiment comprises a step of preparing a piezoelectric material including a region H1 which is an oriented polymeric piezoelectric region. Examples of a step of preparing a piezoelectric material including a region H1 include a method of manufacturing a piezoelectric material comprising: a step of forming raw materials of the piezoelectric material into a film shape; and a step of stretching the formed film. By this step, a piezoelectric material including a region H1 can suitably manufactured.

Examples of a method of manufacturing a piezoelectric material used in the present embodiment include a method of manufacturing a polymeric piezoelectric material according to paragraphs 0065 to 0099 of WO2013/054918.

After preparing a piezoelectric material including a region H1, the piezoelectric material is irradiated with a laser beam having a wavelength of 10,600 nm or less in order to machine the piezoelectric material and to alter the properties of part of the region H1, thereby forming the region L. A laser beam with which the piezoelectric material is irradiated and machining of the piezoelectric material are as described above, and the description thereof will be omitted.

[Layered Body]

Next, a layered body which is formed by using a polymeric piezoelectric layer containing a polymeric piezoelectric material according to the present embodiment will be described in detail. A layered body according to the present embodiment comprises a polymeric piezoelectric layer containing the polymeric piezoelectric material; and a surface layer which is arranged on at least one principle plane of the polymeric piezoelectric layer and which is composed of a thermoplastic resin other than the helical chiral polymer (A).

A layered body according to the present embodiment comprises a surface layer made from a thermoplastic resin. The thermoplastic resin is not particularly limited, and examples thereof include: a polyolefin resin such as a polyethylene resin or a polypropylene resin; a polyvinyl chloride resin; a polystyrene resin; a polyester resin; a poly carbonate resin; a polyurethane resin; and an acryl resin. Among others, a polyester resin is preferable.

As the polyester resin, a polyethylene terephthalate (PET) resin is preferable.

A layered body according to the present embodiment preferably comprises a pressure-sensitive adhesive layer between a polymeric piezoelectric layer and a surface layer. For the pressure-sensitive adhesive layer, for example, an OCA (Optical Clear Adhesive) tape can be employed.

[Manufacturing Method of Layered Body]

A method of manufacturing a layered body according to the present embodiment is not particularly limited.

A layered body according to the present embodiment can be preferably manufactured, for example, by a method comprising: a step of manufacturing a polymeric piezoelectric material by the above-described manufacturing method; and a step of forming, on at least one principal plane of a polymeric piezoelectric layer containing the polymeric piezoelectric material, a surface layer composed of a thermoplastic resin other than the helical chiral polymer (A). After manufacturing a polymeric piezoelectric material including a region L by this method, a surface layer is formed on the polymeric piezoelectric layer containing the polymeric piezoelectric material, whereby a layered body can be manufactured.

A layered body according to the present embodiment can be manufactured by a method other than the above. For example, a layered body can be manufactured by a method comprising: a step of preparing a piezoelectric material conprising a region H1 which is an oriented polymeric piezoelectric region that includes an optically active helical chiral polymer (A) having a weight average molecular weight of from 50,000 to 1,000,000, the region H1 having a crystallinity obtained by a DSC method of from 20% to 80%, and whose standardized molecular orientation measured by a microwave transmission-type molecular orientation meter based on a reference thickness of 50 μm is from 3.5 to 15.0; a step of forming, on at least one principal plane of a piezoelectric layer containing the piezoelectric material, a surface layer composed of a thermoplastic resin other than the helical chiral polymer (A); and a step in which the piezoelectric layer and the surface layer are irradiated with a laser beam having a wavelength of 10,600 nm or less in order to machine the piezoelectric material and to alter the properties of part of the region H1, thereby forming the region L, whereby the piezoelectric layer is made into the polymeric piezoelectric layer including the region H and the region L. After forming a surface layer on the piezoelectric layer containing the piezoelectric material including the region H1 by this method, the piezoelectric layer and the surface layer are irradiated with a laser beam, whereby a layered body can be manufactured.

< Use or the Like of Polymeric Piezoelectric Material and Layered Body >

The polymeric piezoelectric material and the layered body according to the present embodiment can be used in various fields including a speaker, a headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, an acoustic equipment, an information processing equipment, a measurement equipment, and a medical appliance.

In such cases, a polymeric piezoelectric material is preferably used as a piezoelectric element which has at least two planes on which an electrode is provided. The electrode may be provided on at least two planes of the polymeric piezoelectric material. A pressure-sensitive adhesive layer or a substrate layer may be provided between an electrode and the polymeric piezoelectric material. The electrode is not particularly limited, and examples thereof include ITO, ZnO, IGZO, and a conductive polymer.

The polymeric piezoelectric material can be used as a layered piezoelectric element by repeatedly stacking the material and an electrode. For example, a unit of an electrode and a polymeric piezoelectric material is repeatedly stacked on another unit, and a principal plane of the polymeric piezoelectric material which is not covered with an electroded is finally covered with an electrode to form a layered piezoelectric element. Specifically, a layered piezoelectric element having two repeating units is a layered piezoelectric element formed by stacking an electrode, a polymeric piezoelectric material, an electrode, a polymeric piezoelectric material, and an electrode, in the order mentioned. At least one polymeric piezoelectric material which is used for a layered piezoelectric element is a polymeric piezoelectric material according to the present embodiment, and other layers may be not a polymeric piezoelectric material according to the present embodiment.

When a layered piezoelectric element contains a plurality of polymeric piezoelectric materials, if the optical activity of a helical chiral polymer (A) included in a polymeric piezoelectric material of a certain layer is L-form, the helical chiral polymer (A) included in a polymeric piezoelectric material of other layers may be L-form or D-form. Arrangement of a polymeric piezoelectric material can be appropriately adjusted according to a use of a piezoelectric element.

For example, when a first layer of a polymeric piezoelectric material including a helical chiral polymer (A) in L-form as a main component is stacked with a second layer of a polymeric piezoelectric material including a helical chiral

polymer (A) in L-form as a main component via an electrode, it is preferable to cross the uniaxial stretching direction (the main stretching direction) of the first polymeric piezoelectric material with the uniaxial stretching direction (the main stretching direction) of the second polymeric piezoelectric material, preferably perpendicular to each other, since directions of displacements of the first polymeric piezoelectric material and the second polymeric piezoelectric material can be made uniform, thereby increasing the piezoelectricity of the layered piezoelectric element as a whole.

On the other hand, when a first layer of a polymeric piezoelectric material including a helical chiral polymer (A) in L-form as a main component is stacked with a second layer of a polymeric piezoelectric material including a helical chiral polymer (A) in D-form as a main component via an electrode, it is preferable to arrange the uniaxial stretching direction (the main stretching direction) of the first polymeric piezoelectric material substantially in parallel with the uniaxial stretching direction (the main stretching direction) of the second polymeric piezoelectric material, since directions of displacements of the first polymeric piezoelectric material and the second polymeric piezoelectric material can be made uniform, thereby increasing the piezoelectricity of the layered piezoelectric element as a whole.

Particularly when an electrode is provided on the principal plane of a polymeric piezoelectric material, a transparent electrode is preferably provided. Here, a transparent electrode specifically means that its internal haze is 20% or less (total luminous transmittance is 80% or more).

The piezoelectric element using a polymeric piezoelectric material according to the present embodiment may be applied to the above various piezoelectric devices including a speaker and a touch panel. Particularly, a piezoelectric element including a transparent electrode is suitable for application to a speaker, a touch panel, an actuator, or the like.

## Examples

Hereinafter, the invention will be described more specifically by way of Examples. The invention is not limited to the following Examples as long as the present embodiment departs from the gist of the invention.

### [Example 1]

[Manufacturing Polymeric Piezoelectric Material and Layered Body]

< Manufacturing Piezoelectric Material >

A polylactic acid (PLA) (trade name: Ingeo™ biopolymer, brand name: 4032D, weight average molecular weight Mw: 200,000) manufactured by NatureWorks LLC as a helical chiral polymer was placed in a hopper of an extrusion molding machine, extruded from a T-die having a width of 2,000 mm while being heated at from 220°C to 230°C, and brought into contact with a cast roll at 50°C for 0.5 minutes to form a pre-crystallized film having a thickness of 150 μm (molding step). The crystallinity of the obtained pre-crystallized film was measured to be 4.91%.

Stretching of the obtained pre-crystallized film was started at a stretching speed of 165 mm/min by roll-to-roll while the film was heated at 70°C, and the film was stretched up to 3.5-fold uniaxially in the MD direction to obtain a uniaxially stretched film (stretching step).

Thereafter, the uniaxially stretched film was brought into contact with a roll heated to 130°C by roll-to-roll for 78 seconds, and then quenched by a roll which is set to 50°C. The quenched film was slit to cut both end portions thereof evenly in the film width direction to obtain a film having a width of 1,500 mm. The film was further wound into a roll shape to obtain a film-shaped piezoelectric material (anealing step).

(Weight Average Molecular Weight and Molecular Weight Distribution of Helical Chiral Polymer)

By using gel permeation chromatograph (GPC), the weight average molecular weight (Mw) and molecular weight distribution (Mw/Mn) of a helical chiral polymer (polylactic acid) included in the piezoelectric material was measured by the following GPC measurement method.

As the result, Mw was 200,000, and Mw/Mn was 1.9.

- GPC Measurement Method -

• Measurement Apparatus

GPC-100 manufactured by Waters Corp.

• Column

Shodex LF-804 manufactured by Showa Denko K.K.

• Preparation of Sample Solution

The above piezoelectric material was dissolved in a a solvent [chloroform] to prepare a sample solution having a concentration of 1 mg/mL.

• Measurement Condition

0.1 mL of a sample solution was introduced into a column, using a solvent (chloroform), at a temperature of 40°C, and at a flow rate of 1 mL/min, and the sample concentration in the sample solution separated in the column was measured by a differential refractometer. The weight average molecular weight (Mw) of polylactic acid was calculated using a universal calibration curve created based on a polystyrene standard sample.

(Optical Purity of Helical Chiral Polymer)

The optical purity of a helical chiral polymer (polylactic acid) included in the above-described piezoelectric material was measured in the following manner.

Firtst, 1.0 g of a sample (the above-described piezoelectric material) was measured and placed into a 50 mL-conical flask, and 2.5 mL of IPA (isopropyl alcohol) and 5 mL of 5.0 mol/L sodium hydroxide solution were added the flask to prepare a sample solution.

Next, the conical flask including the sample solution was placed in a water bath having a temperature of 40°C, and the sample solution was stirred for about 5 hours until the polylactic acid was completely hydrolyzed.

The sample solution after being stirred for about 5 hours was cooled to room temperature, and then, 20 mL of 1.0 mol/L hydrochloric acid solution was added thereto to be neutralized, followed by stirring with the conical flask tightly sealed.

Next, 1.0 mL of the sample solution stirred above was put in a 25 mL-measuring flask, and a mobile phase of the following composition was added thereto, to obtain 25 mL of an HPLC sample solution 1.

Five μL of the obtained HPLC sample solution 1 was poured into an HPLC apparatus, and HPLC measurement was performed by the following HPLC measurement conditions. From the obtained measurement result, an area of a peak derived from polylactic acid in D-form and an area of a peak derived from polylactic acid in L-form were determined to calculate the L-form amount and the D-form amount.

Based on the obtained result, the optical purity (%ee) was determined.

As the result, the optical purity was 97.0%ee.

- HPLC Measurement Conditions -

Optical resolution column, SUMICHIRAL OA5000 manufactured by Sumika Chemical Analysis Service, Ltd.

• HPLC apparatus

Liquid chromatography manufactured by JASCO Corporation

• Column Temperature 25°C

• Composition of Mobile Phase

$$1.0\ \text{mM-copper sulfate (II) buffer solution /IPA} = 98/2(\text{V/V})$$

(In this mobile phase, the ratio of copper sulfate (II), IPA, and water is copper sulfate (II) /IPA /water = 156.4 mg /20 mL /980 mL.)

Mobile phase flow rate

1.0 mL/min

• Detector

Ultraviolet detector (UV254 nm)

(Internal Haze)

An internal haze (H1) of a piezoelectric material was measured by the following method.

Results are shown in Table 1.

First, a layered body which was obtained by sandwitching only a silicone oil (SHIN-ETSU SILICONE (trade mark), model number: KF96-100CS manufactured by Shin-Etsu Chemical Co., Ltd.) between two glass plates was prepared, and a haze (hereinafter, referred to as "haze (H2)") of the layered body in the thickness direction was measured.

Next, a layered body which was obtained by sandwitching a piezoelectric material on the surface of which a silicone oil was uniformly applied between the two glass plates was prepared, and a haze (hereinafter, referred to as "haze (H3)") of the layered body in the thickness direction was measured.

Next, the internal haze (H1) of the piezoelectric material was obtained by calculating the difference between the two values according to the following formula.

$$\text{Internal haze (H1)} = \text{haze (H3)} - \text{haze (H2)}$$

Here, measurements of the haze (H2) and the haze (H3) were each performed by using the following apparatus under the following measurement condition.

Measurement apparatus: HAZE METER TC-HIII DPK manufactured by Tokyo Denshoku Co., LTD.
Sample size: width 30 mm × length 30 mm
Measurement condition: In accordance with JIS-K7105
Measurement temperature: Room temperature (25°C)

(Standardized Molecular Orientation MORc)

By using a microwave molecular orientation meter MOA-6000 manufactured by Oji Scientific Instruments, the standardized molecular orientation MORc of the above piezoelectric material was measured. The criteria thickness tc was set to 50 μm.

Results are shown in Table 1.

(Degree of Crystallinity)

10 mg of the above-described piezoelectric material was accurately weighed, and for the 10 mg of weighed piezoelectric material, measurement was performed by using a differential scanning calorimetry (DSC -1 manufactured by Perkin Elmer Co., Ltd.) at a temperature rising rate of 10°C/min to obtain a melting endothermic curve. From the obtained melting endothermic curve, the crystallinity was obtained.

Results are shown in Table 1.

Next, an OCA (Optical Clear Adhesive) (brand name: 5402A-50) manufactured by Sekisui Chemical Co., Ltd. was stuck to two principal planes of a piezoelectric material manufactured as described above by a 2 kg-roll, and then a polyethylene terephthalate resin (PET) (brand name: LUMIRROR T60-50) manufactured by Toray Industries, Inc. was stuck to a surface of the OCA opposite to the piezoelectric material. By this, a layered structure formed by layering five layers was obtained. In other words, the layered structure is composed of five layers: PET /OCA /PLA /OCA /PET.

The piezoelectric material and the layered structure obtained as described above were cut by laser beam irradiation. Irradiation conditions of a laser beam are as follows.

< Irradiation Condition of Laser Beam >

Laser beam source: Carbon dioxide laser
Laser wavelength: 10,600 nm
Spot diameter: 150 μm
Scanning speed (machining speed): 60 m/min (1,000 mm/second)
Power: 400W

By cutting a piezoelectric material including a region H1 by laser beam irradiation under the above irradiation conditions, a polymeric piezoelectric material in which a region L was formed at part of an end portion of the region H1 as illustrated in Fig. 1 was obtained. The average width of the region L of the obtained polymeric piezoelectric material was 50 μm. The average width of the region L was calculated by averaging widths at five points on the region L measured by a Birefringence Measurement System WPA-Micro (Photonic Lattice, Inc.).
By cutting the layered structure by a laser beam under the above-described conditions, a layered body (50 mm × 50 mm) comprising a polymeric piezoelectric layer in which the region L was formed at part of an end portion of the region H1 was obtained.
With respect to a polymeric piezoelectric material obtained by removing OCA and PET from the layered body obtained above, measurement of retardation at a wavelength of 550 nm was performed by using a Birefringence Measurement System WPA-Micro (Photonic Lattice, Inc.).
The birefringence is represented by a value obtained by dividing the retardation by the thickness of the polymeric piezoelectric material.
Results are shown in Table 1.

(Piezoelectric Constant $d_{14}$)

The piezoelectric constant $d_{14}$ of the polymeric piezoelectric material (including the region H and the region L) was measured according to one example of a method of measuring the piezoelectric constant $d_{14}$ by the stress-charge method (25°C) as described above.
Specifically, an electrically conductive Al layer was formed on a polymeric piezoelectric material, and then a laser processing was performed to manufacture a 120 mm × 10 mm rectangle film, which was to be used as a sample for piezoelectric constant measurement.
Results are shown in Table 1.

(MD Crack)

The thus obtained layered body (50 mm × 50 mm) was heated at 85°C for 500 hours, and then was left to stand at room temperature for 24 hours. Presence or absence of crack generation in the MD direction was observed by visual inspection, and evaluation was performed by the following criteria.

○: No crack was observed in a polylactic acid layer (a polymeric piezoelectric layer) of a layered body.
×: a crack was generated in a polylactic acid layer (a polymeric piezoelectric layer) of a layered body.

(Air Inclusion at End Portion)

For the layered body (50 mm × 50 mm) obtained as described above, an air inclusion at an end portion was determined. Specifically, the outer appearance of the layered body on which an OCA sheet-attached polyethylene terephthalate resin was stuck was evaluated by visual inspection to determine whether there was an air inclusion at an end portion thereof or not.

[Table 1]

| | Cutting Condition | High Orientation Polymeric Piezoelectric Region | | | | Low Orientation Region | | | $d_{14}$ [pC/N] | MD Crack | Air Inclusion at End Portion |
|---|---|---|---|---|---|---|---|---|---|---|---|
| | | Degree of Crystallinity [%] | Standardized Molecular Orientation | Birefringence | Internal Haze [%] | Average Width [μm] | Retardation [nm] | Birefringence | | | |
| Example 1 | $CO_2$ Laser (10,600 nm) Output400W Machining Speed 1000 mm/s | 38.5 | 4.30 | 0.021 | 0.2 | 50 | 51 | 0.0004 | 6.41 | ○ | None |
| Example 2 | $CO_2$ Laser (10,600 nm) Output400W Machining Speed 500 mm/s | 38.5 | 4.30 | 0.021 | 0.2 | 90 | 33 | 0.0004 | 6.34 | ○ | None |
| Comparative Example 1 | Pinnacle Blade Punching | 38.5 | 4.30 | 0.021 | 0.2 | 0 | - | - | 6.48 | × | None |
| Comparative Example 2 | Soldering Iron | 38.5 | 4.30 | 0.021 | 0.2 | 380 | 18 | 0.0002 | 5.77 | ○ | Yes |

[Example 2]

In Example 2, a polymeric piezoelectric material and a layered body were manufactured under similar conditions to those of Example 1 except that a scanning speed which was an irradiation condition of a laser beam was changed to 30 m/min (500 mm/second).

The measurement results in Example 2 are shown in Table 1.

[Comparative Example 1]

In Comparative Example 1, pinnacle blade punching was performed on the above-described piezoelectric material and a layered structure formed by layering five layers, without machining by laser beam irradiation. A piezoelectric material not including a low orientation region (region L) and a layered body comprising a piezoelectric layer not including a low orientation region were then manufactured.

The measurement results in Comparative Example 1 are shown in Table 1.

[Comparative Example 2]

In Comparative Example 2, a melting processing using a soldering iron was performed on the above-described polymeric piezoelectric material and a layered structure formed by layering five layers, without machining by laser beam irradiation. A polymeric piezoelectric material and a layered body comprising a piezoelectric layer including a low orientation region (region L) were then manufactured. The width of the region L was 380 μm.

The measurement results in Comparative Example 2 are shown in Table 1.

In Examples 1 and 2, generation of a crack in a polymeric piezoelectric layer of a layered body was suppressed, an end portion of a layered body was not projected, and an air inclusion was not observed on the entire surface including end portions.

On the other hand, in Comparative Example 1 in which a region L was not formed, generation of a crack in a piezoelectric layer of a layered body could not be suppressed, and in Comparative Example 2 in which the width of the region L was 380 μm, the piezoelectricity was decreased, and an air inclusion was obserbed at an end portion.

Accordingly, it has been found that, by providing a low orientation region having a predetermined width near at least part of an end portion of an oriented polymeric piezoelectric region in a polymeric piezoelectric layer, generation of a crack in a polymeric piezoelectric layer of a layered body can be suppressed while maintaining the piezoelectricity, and generation of an air inclusion at the end portion can be suppressed.

Japanese Patent Application No. 2014-136759 filed on July 2, 2014 is incorporated herein by reference in its entirety.

All the documents, patent applications, and technical standards described here are incorporated herein by reference to the same extent as the case in which each individual document, patent application, or technical standard is specifically and individually indicated to be incorporated by reference.

## Claims

**1.** A polymeric piezoelectric material, comprising at least two regions, the at least two regions comprising:

a region H, which is an oriented polymeric piezoelectric region that includes an optically active helical chiral polymer (A) having a weight average molecular weight of from 50,000 to 1,000,000, the region H having a crystallinity obtained by a DSC method of from 20% to 80% and having a standardized molecular orientation measured by a microwave transmission-type molecular orientation meter based on a reference thickness of 50 μm of from 3.5 to 15.0; and

a region L, which is a low orientation region that includes the optically active helical chiral polymer (A) having a weight average molecular weight of from 50,000 to 1,000,000, the region L being present near at least part of an end portion of the region H, having an average width when viewed from a normal direction with respect to the principal plane of the region H of from 10 μm to 300 μm, and having a retardation is 100 nm or less.

**2.** The polymeric piezoelectric material according to claim 1, wherein the region L is at least present near an end portion of the region H which intersects the direction of molecular orientation of the region H.

**3.** The polymeric piezoelectric material according to claim 1 or 2, wherein a piezoelectric constant $d_{14}$ measured at 25°C by a stress-charge method is 1 pC/N or more.

4. The polymeric piezoelectric material according to any one of claims 1 to 3, wherein a product of the standardized molecular orientation and the crystallinity of the region H is from 25 to 700.

5. The polymeric piezoelectric material according to any one of claims 1 to 4, wherein the region H has an internal haze with respect to visible light of 50% or less.

6. The polymeric piezoelectric material according to any one of claims 1 to 5, wherein the helical chiral polymer (A) is polylactic acid-type polymer having a main chain containing a repeating unit represented by the following Formula (1):

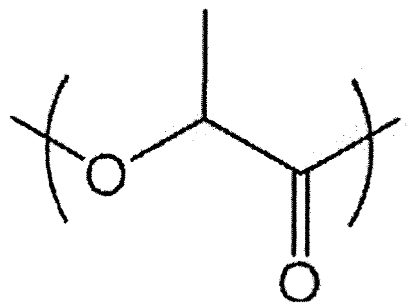

(1)

7. The polymeric piezoelectric material according to any one of claims 1 to 6, wherein the region L is a region formed by irradiation of a laser beam having a wavelength of 12,000 nm or less.

8. A layered body, comprising:

a polymeric piezoelectric layer containing the polymeric piezoelectric material according to any one of claims 1 to 7; and
a surface layer, which is arranged on at least one principle plane of the polymeric piezoelectric layer, and which is composed of a thermoplastic resin other than the helical chiral polymer (A).

9. The layered body according to claim 8, wherein the thermoplastic resin is a polyester resin.

10. The layered body according to claim 8 or 9, further comprising a pressure-sensitive adhesive layer between the polymeric piezoelectric layer and the surface layer.

11. A method of manufacturing the polymeric piezoelectric material according to any one of claims 1 to 7, the method comprising:

preparing a piezoelectric material comprising a region H1, which is an oriented polymeric piezoelectric region that includes an optically active helical chiral polymer (A) having a weight average molecular weight of from 50,000 to 1,000,000, the region H1 having a crystallinity obtained by a DSC method of from 20% to 80%, and having a standardized molecular orientation measured by a microwave transmission-type molecular orientation meter based on a reference thickness of 50 μm of from 3.5 to 15.0; and
irradiating the piezoelectric material with a laser beam having a wavelength of 10,600 nm or less in order to machine the piezoelectric material and to alter the properties of a part of the region H1, thereby forming the region L, whereby the piezoelectric material is made into a polymeric piezoelectric material including the region H and the region L.

12. A method of manufacturing a layered body, the method comprising:

manufacturing a polymeric piezoelectric material by the manufacturing method according to claim 11; and
forming, on at least one principal plane of a polymeric piezoelectric layer containing the polymeric piezoelectric material, a surface layer composed of a thermoplastic resin other than the helical chiral polymer (A).

13. A method of manufacturing the layered body according to any one of claims 8 to 10, the method comprising:

preparing a piezoelectric material comprising a region H1, which is an oriented polymeric piezoelectric region that includes an optically active helical chiral polymer (A) having a weight average molecular weight of from

50,000 to 1,000,000, the region H1 having a crystallinity obtained by a DSC method of from 20% to 80%, and having a standardized molecular orientation measured by a microwave transmission-type molecular orientation meter based on a reference thickness of 50 μm of from 3.5 to 15.0;
forming, on at least one principal plane of a piezoelectric layer containing the piezoelectric material, a surface layer composed of a thermoplastic resin other than the helical chiral polymer (A); and
irradiating the piezoelectric layer and the surface layer with a laser beam having a wavelength of 10,600 nm or less in order to machine the piezoelectric material and to alter the properties of part of the region H1, thereby forming the region L, whereby the piezoelectric layer is made into the polymeric piezoelectric layer including the region H and the region L.

Fig. 1

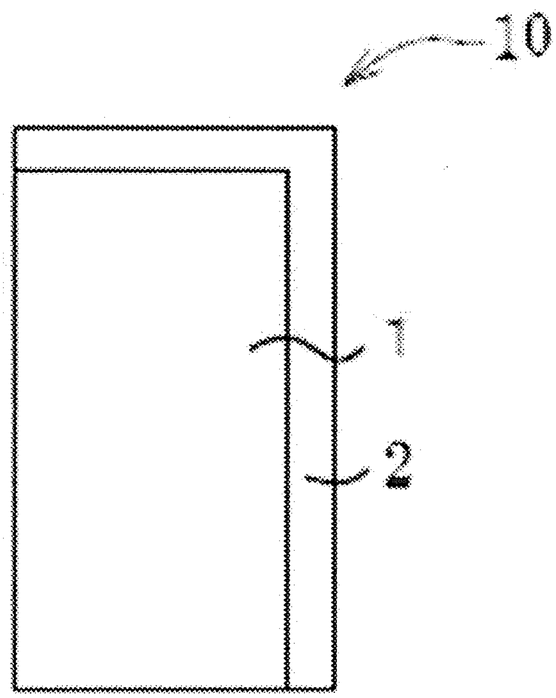

## INTERNATIONAL SEARCH REPORT

International application No.
PCT/JP2015/068231

A. CLASSIFICATION OF SUBJECT MATTER
*H01L41/193*(2006.01)i, *B32B7/02*(2006.01)i, *B32B27/36*(2006.01)i, *C08L67/04*(2006.01)i, *C08L101/16*(2006.01)i, *H01L41/053*(2006.01)i, *H01L41/083*(2006.01)i, *H01L41/09*(2006.01)i, *H01L41/253*(2013.01)i,

According to International Patent Classification (IPC) or to both national classification and IPC

B. FIELDS SEARCHED

Minimum documentation searched (classification system followed by classification symbols)
H01L41/193, B32B7/02, B32B27/36, C08L67/04, C08L101/16, H01L41/053, H01L41/083, H01L41/09, H01L41/253, H01L41/45

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2014-093487 A (Mitsui Chemicals, Inc.), 19 May 2014 (19.05.2014), entire text; all drawings (Family: none) | 1-13 |
| A | JP 2012-235086 A (Mitsui Chemicals, Inc.), 29 November 2012 (29.11.2012), entire text; all drawings & US 2012/0132846 A1 & WO 2012/026494 A1 & EP 2469618 A1 & CN 102484199 A & KR 10-2012-0058536 A | 1-13 |
| A | JP 2014-027038 A (Teijin Ltd. et al.), 06 February 2014 (06.02.2014), entire text; all drawings (Family: none) | 1-13 |

☐ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 27 August 2015 (27.08.15) | 08 September 2015 (08.09.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.
PCT/JP2015/068231

Continuation of A. CLASSIFICATION OF SUBJECT MATTER
(International Patent Classification (IPC))

*H01L41/45*(2013.01)i

(According to International Patent Classification (IPC) or to both national classification and IPC)

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H05152638 A
- JP 2005213376 A
- WO 2013054918 A
- JP S59096123 A
- JP H07033861 A
- US 2668182 A
- US 4057357 A
- JP 2014136759 A